# EUROPEAN PATENT APPLICATION

(11) **EP 1 061 582 A2**
(43) Date of publication of application: **20.12.2000**
(21) Application number: 00112600.2
(22) Date of filing: 14.06.2000
(51) Int. Cl.: H01L 27/108, H01L 21/8242, H01L 29/92, H01L 21/02

(54) **Capacitor and method of fabricating the same**

(30) Priority: 16.06.1999 JP 16926299
(71) Applicant: Matsushita Electronics Corporation, Takatsuki-shi, Osaka 569-1193 (JP)
(72) Inventor: Noma, Atsushi, Takatsuki-shi, Osaka 569-1147 (JP); Nakao, Keisaku, Tokyo 143-0023 (JP); Uemoto, Yasuhiro, Otsu-shi, Shiga 520-0837 (JP)
(74) Representative: Grünecker, Kinkeldey, Stockmair & Schwanhäusser Anwaltssozietät

(57) **Abstract**

A protective insulating film is deposited on a field-effect transistor formed on a semiconductor substrate. A contact plug having a lower end portion connected to an impurity diffusion layer of the field-effect transistor is formed in the protective insulating film. A conductive diffusion preventing film connected to an upper end portion of the contact plug is formed on the protective insulating film. A capacitor lower electrode is formed on the diffusion preventing film. Sidewalls made of an oxidation resistant material are formed on at least the side surfaces of the diffusion preventing film. A capacitor insulating film made of an insulating metal oxide is formed over the capacitor lower electrode and the sidewalls. A capacitor upper electrode is formed on the capacitor insulating film.

## Description

### BACKGROUND OF THE INVENTION

The present invention relates to a semiconductor device comprising a capacitor having a capacitor insulating film composed of an insulating metal oxide film such as a ferroelectric film or a high-dielectric-constant film and to a method of fabricating the same.

With the advancement of digital technology in recent years, there have been increasing tendencies to process or store a larger amount of data. Under such circumstances, electronic equipment has been more sophisticated than ever, which has rapidly increased the integration density of a semiconductor integrated circuit used in the electronic equipment and promoted the miniaturization a semiconductor element used therein.

To increase the integration density of a dynamic RAM composing the semiconductor integrated circuit, research and development has been conducted widely on a technique using a ferroelectric film or a high-dielectric-constant film as a capacitor insulating film in place of a silicon oxide film or a silicon nitride film that has been used conventionally.

To implement an actually usable nonvolatile RAM which operates at a low voltage and permits a high-speed write or read operation performed thereto, vigorous research and development has been conducted on a ferroelectric film having the property of spontaneous polarization.

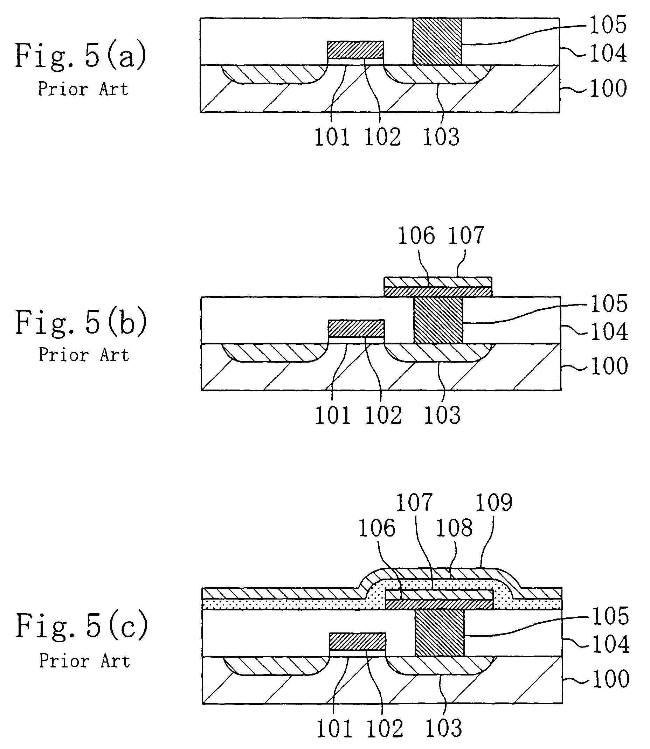

Referring now to Figures **5(a)** to **5(c)**, a conventional semiconductor device comprising a capacitor having a capacitor insulating film made of an insulating metal oxide and a fabrication method therefore will be described.

First, as shown in Figure **5(a)**, a gate electrode **102** is formed on a semiconductor substrate **100** with a gate insulating film **101** interposed therebetween. Then, impurity ions are implanted into the semiconductor substrate **100** by using the gate electrode **102** as a mask, whereby impurity diffusion layers **103** each serving as a source or drain region of a field-effect transistor is formed. Subsequently, a protective insulating film **104** is deposited over the entire surface of the semiconductor substrate **100**. Thereafter, a contact hole is formed in the protective insulating film **104** and a polysilicon film is filled in the contact hole, thereby forming a contact plug **105** connected to the impurity diffusion layer **103**.

Next, as shown in Figure **5(b)**, a titanium nitride film and a multi-layer film consisting of a lower iridium film and an upper iridium oxide film are deposited over the entire surface of the protective insulating film **104**. The titanium nitride film and the multi-layer film are then patterned to form a diffusion preventing film **106** composed of the titanium nitride film and a capacitor lower electrode **107** composed of the multi-layer film.

Next, as shown in Figure **5(c)**, a capacitor insulating film **108** made of an insulating metal oxide and a capacitor upper electrode **109** are formed in such a manner as to cover the capacitor lower electrode **107**, whereby the capacitor composed of the capacitor lower electrode **107**, the capacitor insulating film **108**, and the capacitor upper electrode **109** is obtained.

The conventional semiconductor device and the fabrication method therefor have the following characteristics.

First, since the diffusion preventing film **106** is interposed between the contact plug **105** and the capacitor lower electrode **107**, there can be circumvented a situation in which a high resistance layer is formed due to interdiffusion between the contact plug **105** and the capacitor lower electrode **107** in a heat treatment process subsequently performed and the capacitor lower electrode **107** of the capacitor peels off the protective insulating film **104** during the fabrication process.

Because of the diffusion preventing film **106** interposed between the contact plug **105** and the capacitor lower electrode **107**, however, oxygen in an oxygen atmosphere is diffused in the capacitor lower electrode **107** to reach the diffusion preventing film **106** during a heat treatment step performed in the oxygen atmosphere to improve the crystallinity of the insulating metal oxide film composing the capacitor insulating film **108** or oxygen in the insulating metal oxide film composing the capacitor insulating film **108** is diffused in the capacitor lower electrode **107** to reach the diffusion preventing film **106** during a general heat treatment step. This causes a new problem of a high resistance layer formed through the oxidation of titanium nitride composing the diffusion preventing film **106**.

To prevent the problem, the capacitor lower electrode **107** has been formed of the multi-layer film composed of the lower iridium film and the upper iridium oxide film such that oxygen is prevented from being diffused in the capacitor lower electrode **107** and reaching the diffusion preventing film **106**.

Moreover, since the capacitor insulating film **108** which is hard to etch is deposited after the capacitor lower electrode **107** is formed by patterning the multi-layer film which is composed of the iridium film and the iridium oxide film and easy to etch, the feature size of the capacitor can be decreased easily so that higher integration is achieved.

In the process of inspecting the properties of the capacitor of the semiconductor device obtained in accordance with the foregoing method, the present inventors noticed that oxygen had entered the diffusion preventing film and thereby degraded the properties of the capacitor irrespective of the capacitor lower electrode which was formed of the multi-layer film consisting of the iridium film and the iridium oxide film with the view to preventing oxygen in the atmosphere or in the insulating metal oxide composing the capacitor insulating film from entering the diffusion preventing film.

As a result of making a wide variety of examinations on the cause of the entrance of oxygen into the diffusion preventing film, the present inventors have found that oxygen entered the diffusion preventing film for the following reason.

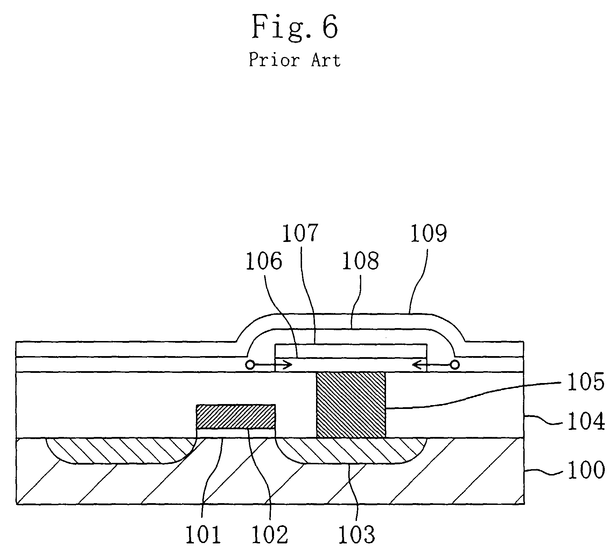

Since the capacitor lower electrode **107** is formed of the multi-layer film consisting of the lower iridium film and the upper iridium oxide film, as described above, there can be circumvented a situation in which oxygen in the oxygen atmosphere or in the insulating metal oxide composing the capacitor insulating film **108** is diffused in the capacitor lower electrode **107** to reach the diffusion preventing film **106** in the heat treatment step. However, the present inventors encountered the problem that oxygen in the oxygen atmosphere or in the insulating metal oxide composing the capacitor insulating film **108** entered the diffusion preventing film **106** from the side surfaces thereof as indicated by the arrows in Figure **6**, thereby oxidizing titanium nitride composing the diffusion preventing film **106** and forming the high resistance layer.

When the high resistance layer is formed in the diffusion preventing film **106**, a contact resistance between the contact plug **105** and the diffusion preventing film **106** increases so that the intensity of an electric field applied to the capacitor insulating film **108** lowers. This reduces charge accumulated in the capacitor insulating film **108** and leads to the problem of the capacitor with lower performance.

### SUMMARY OF THE INVENTION

In view of the foregoing, it is therefore an object of the present invention to prevent oxygen in an oxygen atmosphere or in an insulating metal oxide composing a capacitor insulating film from entering a diffusion preventing film from the side surfaces thereof.

To attain the object, a semiconductor device according to the present invention comprises: a protective insulating film deposited on a semiconductor substrate having a field-effect transistor formed thereon; a contact plug formed in the protective insulating film to have a lower end portion connected to an impurity diffusion layer serving as a source or drain region of the field-effect transistor; a conductive diffusion preventing film formed on the protective insulating film and connected to an upper end portion of the contact plug; sidewalls made of an oxidation resistant material and formed on at least side surfaces of the diffusion preventing film; a capacitor lower electrode formed on the diffusion preventing film; a capacitor insulating film made of an insulating metal oxide and formed over the capacitor lower electrode and the sidewalls; and a capacitor upper electrode formed on the capacitor insulating film.

Since the semiconductor device according to the present invention comprises the sidewalls made of an oxidation resistant material and covering at least the side surfaces of the diffusion preventing film, even when an insulating metal oxide film forming the capacitor insulating film is formed in an oxygen atmosphere at a high temperature, oxygen in the oxygen atmosphere and oxygen in the insulating metal oxide film is less likely to be diffused in the sidewalls. As a result, oxygen is less likely to enter the diffusion preventing film, which prevents a situation in which a high resistance layer is formed through the oxidation of the diffusion preventing film. Accordingly, the amount of charge accumulated in the capacitor insulating film increases significantly when a voltage is applied between the semiconductor substrate and the capacitor upper electrode so that the properties of the capacitor are improved.

In the semiconductor device according to the present invention, the sidewalls are preferably made of silicon nitride.

When the sidewalls are thus formed of silicon nitride having eminently high resistance to oxidation, oxygen in the oxygen atmosphere or oxygen in the insulating metal oxide forming a capacitor insulating film is seldom diffused in the sidewalls, which positively prevents a situation in which the high resistance layer is formed through the oxidation of the diffusion preventing film.

In the semiconductor device according to the present invention, the sidewalls are preferably made of an insulating metal oxide.

In the arrangement, there can be circumvented a situation in which oxygen in the oxygen atmosphere or oxygen in the insulating metal oxide forming a capacitor insulating film is diffused in the sidewalls to enter the diffusion preventing film.

In this case, the metal oxide is preferably aluminum oxide, zirconium oxide, iridium oxide, rhodium oxide, or ruthenium oxide.

In the arrangement, oxygen is less likely to be generated from a metal oxide composing the sidewalls so that the formation of a high resistance layer in the diffusion preventing film due to oxygen in the metal oxide is prevented.

In the semiconductor device according to the present invention, the capacitor insulating film is preferably made of a ferroelectric material having a bismuth layered perovskite structure, lead zirconate titanate (PZT), strontium barium titanate, or tantalum pentaoxide.

In the semiconductor device according to the present invention, the diffusion preventing film is preferably composed of a single-layer or multi-layer film having a film made of titanium, tantalum, tungsten, aluminum, or an alloy thereof or a film made of titanium nitride, tantalum nitride, tungsten nitride, aluminum nitride, or an alloy thereof.

The arrangement prevents a situation in which a high resistance layer is formed due to interdiffusion between the contact plug and the capacitor lower electrode and the capacitor lower electrode of the capacitor peels off the protective insulating film in the fabrication process.

A method of fabricating a semiconductor device according to the present invention comprises the steps of: depositing a protective insulating film on a semiconductor substrate having a field-effect transistor formed thereon; forming a contact plug in the protective insulating film such that a lower end portion of the contact plug is connected to an impurity diffusion layer serving as a source or drain region of the field-effect transistor; forming a conductive diffusion preventing film on the protective insulating film such that the diffusion preventing film is connected to an upper end portion of the contact plug; forming a capacitor lower electrode on the diffusion preventing film; depositing a film made of an oxidation resistant material over the protective insulating film and the capacitor lower electrode, performing anisotropic dry etching with respect to the film made of the oxidation resistant material, and thereby forming sidewalls made of the oxidation resistant material on at least side surfaces of the diffusion preventing film; forming a capacitor insulating film made of an insulating metal oxide over the capacitor lower electrode and the sidewalls; and forming a capacitor upper electrode on the capacitor insulating film.

In accordance with the method of fabricating a semiconductor device according to the present invention, the capacitor insulating film made of the insulating metal oxide is formed after the sidewalls made of an oxidation resistant material are formed on at least the side surfaces of the diffusion preventing film. Even if the insulating metal oxide film forming the capacitor insulating film is formed in an oxygen atmosphere at a high temperature, oxygen in the oxygen atmosphere and oxygen in the insulating metal oxide film is less likely to be diffused in the sidewalls. As a result, oxygen is less likely to enter the diffusion preventing film, which prevents a situation in which the high resistance layer is formed through the oxidation of the diffusion preventing film.

### BRIEF DESCRIPTION OF THE DRAWINGS

Figure **1** is a cross-sectional view of a semiconductor device according to an embodiment of the present invention;
Figures **2(a)** to **(c)** are cross-sectional views illustrating the individual process steps of a method of fabricating the semiconductor device according to the embodiment;
Figures **3(a)** and **(b)** are cross-sectional views illustrating the individual process steps of the method of fabricating the semiconductor device according to the embodiment;
Figure **4** is a view showing for comparison the respective properties of the semiconductor device according to the embodiment of the present invention and a conventional semiconductor device;
Figures **5(a)** to **(c)** are cross-sectional views illustrating the individual process steps of a conventional method of fabricating the semiconductor device; and
Figure **6** is a cross-sectional view illustrating problems associated with the conventional semiconductor device.

### DETAILED DESCRIPTION OF THE INVENTION

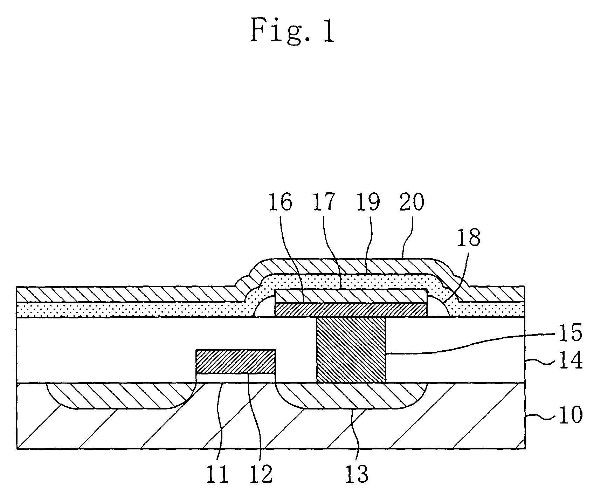

A semiconductor device according to an embodiment of the present invention will be described with reference to Figure **1**.

As shown in Figure **1**, a gate electrode **12** is formed on a semiconductor substrate **10** with a gate insulating film **11** interposed therebetween. Impurity diffusion layers **13** each serving as the source or drain region of a field-effect transistor are formed in a surface portion of the semiconductor substrate **10** to be located on both sides of the gate electrode **12**.

A protective insulating film **14** composed of, e.g., a silicon oxide film is deposited on the semiconductor substrate **10** in such a manner as to cover the field-effect transistor. A contact plug **15** composed of a polysilicon film having a lower end portion connected to the impurity diffusion layer **13** is buried in the protective insulating film **14**.

A diffusion preventing film **16** composed of a titanium nitride film is provided on the protective insulating film **14**. The diffusion preventing film **16** is connected to an upper end portion of the contact plug **15**. A capacitor lower electrode **17** composed of a multi-layer film consisting of a lower iridium film and an upper iridium oxide film is provided on the diffusion preventing film **16**.

The present embodiment is characterized in that sidewalls **18** made of silicon nitride are provided on the respective side surfaces of the diffusion preventing film **16** and the capacitor lower electrode **17** in such a manner as to cover the entire side surfaces of the diffusion preventing film **16** and a part of the side surfaces of the capacitor lower electrode **17**.

A capacitor insulating film **19** made of a ferroelectric material such as SrBi₂(Ta₁₋ₓNbₓ)O₉ having a bismuth layered perovskite structure is formed on the capacitor lower electrode **17** in such a manner as to cover the capacitor lower electrode **17**. A capacitor upper electrode **20** is provided on the capacitor insulating film **19**. The foregoing capacitor lower electrode **17**, the capacitor insulating film **19**, and the capacitor upper electrode **20** constitute a capacitor for storing data. The capacitor and the foregoing field-effect transistor constitute a memory cell.

The diffusion preventing film **16** made of titanium nitride prevents the formation of a high resistance layer due to interdiffusion between the contact plug **15** and the capacitor lower electrode **17** in a heat treatment step performed subsequently, while preventing the peeling of the capacitor lower electrode **17** off the protective insulating film **14** during the fabrication process.

The capacitor lower electrode **17** composed of the multi-layer film consisting of the iridium film and the iridium oxide film **17** prevents oxygen in an oxygen atmosphere or oxygen in the insulating metal oxide composing the capacitor insulating film **19** from being diffused in the capacitor lower electrode **17** and reaching the diffusion preventing film **16**.

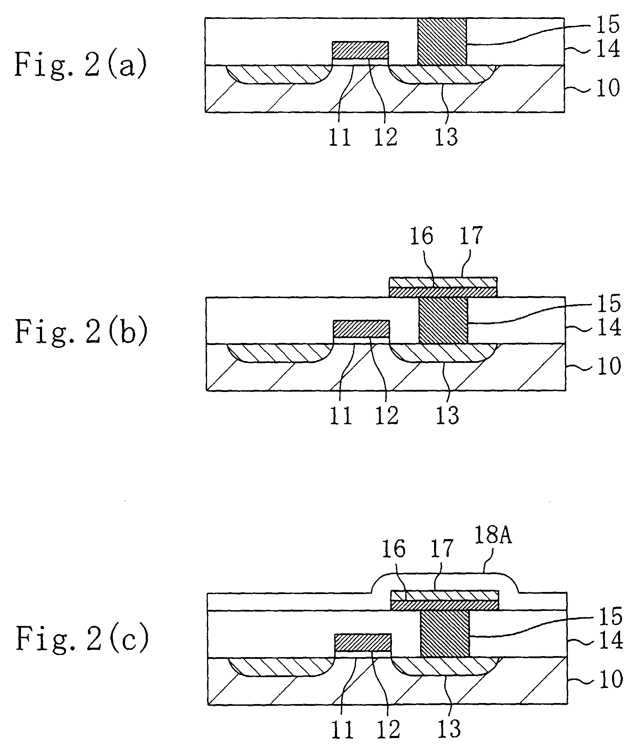

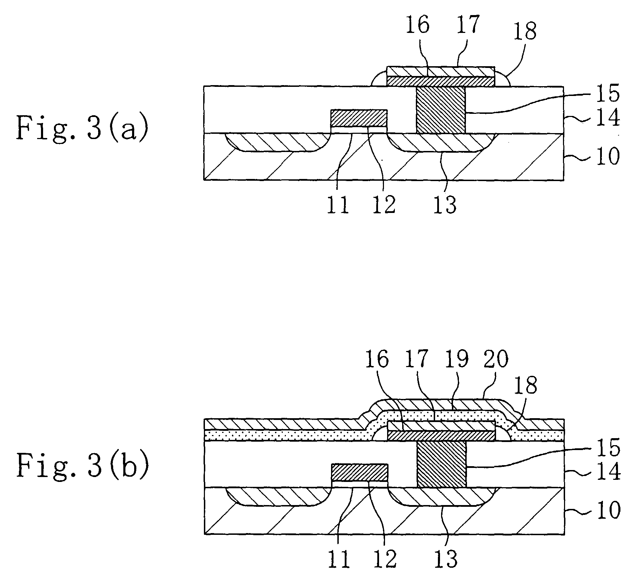

Referring now to Figures **2(a)** to **(c)** and Figures **3(a)** and **(b)**, a description will be given to a method of fabricating the semiconductor device according to the embodiment.

First, as shown in Figure **2(a)**, the gate electrode **12** is formed on the semiconductor substrate **10** with the gate insulating film **11** interposed therebetween. Then, impurity ions are implanted into the semiconductor substrate **10** by using the gate electrode **12** as a mask, whereby the impurity diffusion layers **13** each serving as the source or drain region of the field-effect transistor are formed. Subsequently, the protective insulating film **14** made of, e.g., silicon oxide is deposited on the semiconductor substrate **10** in such a manner as to cover the field-effect transistor. Thereafter, a contact hole is formed in the protective insulating film **14** and a polysilicon film, e.g., is filled in the contact hole by, e.g., CVD, thereby forming the contact plug **15** having a lower end portion connected to the impurity diffusion layer **13**.

Next, a titanium nitride film, an iridium film, and an iridium oxide film are deposited successively over the entire surface of the protective insulating film **14**. The films are then patterned so that the diffusion preventing film **16** composed of the titanium nitride film and connected to the upper end portion of the contact plug **15** is formed and that the capacitor lower electrode **17** composed of the multi-layer film consisting of the iridium film and the iridium oxide film is formed on the diffusion preventing film **16**, as shown in Figure **2(b)**.

Next, as shown in Figure **2(c)**, a silicon nitride film **18A** is deposited over the entire surface of the protective insulating film **14**. Thereafter, anisotropic dry etching using a RIE process is performed with respect to the silicon nitride film **18A**, thereby forming the sidewalls **18** on the respective side surfaces of the diffusion preventing film **16** and the capacitor lower electrode **17** such that the side surfaces of the diffusion preventing film **16** are entirely covered therewith and the side surfaces of the capacitor lower electrode **17** are partially covered therewith, as shown in Figure **3(a)**.

Next, as shown in Figure **3(b)**, the capacitor insulating film **19** made of a ferroelectric material having a bismuth layered perovskite structure, such as SrBi₂(Ta₁₋ₓNbₓ)O₉, is formed entirely over the capacitor lower electrode **17** and the sidewalls **18** by metal organic decomposition (MOD), metal organic chemical vapor deposition (MOCVD), or sputtering. As a method of depositing the ferroelectric film, there may be listed one in which the ferroelectric film is deposited in an oxygen atmosphere at a high temperature of 500 °C or higher or in which the ferroelectric material is formed at a low temperature and subjected to heat treatment performed in an oxygen atmosphere at a high temperature. Then, the capacitor upper electrode **20** composed of a platinum film is deposited on the capacitor insulating film **19**, whereby the semiconductor device according to the present embodiment is completed.

In the semiconductor device according to the present embodiment and the fabrication method therefor, the sidewalls **18** covering at least the side surfaces of the diffusion preventing film **16** are provided on the respective side surfaces of the diffusion preventing film **16** and the capacitor lower electrode **17**. Since silicon nitride composing the sidewalls **18** has extremely high resistance to oxidation, even if a ferroelectric film is formed in an oxygen atmosphere at a high temperature, oxygen in the oxygen atmosphere and oxygen in the ferroelectric film is not diffused in the sidewalls **18**. This prevents oxygen from entering the diffusion preventing film **16** and thereby prevents the formation of a high resistance layer through the oxidation of titanium nitride composing the diffusion preventing film **16**.

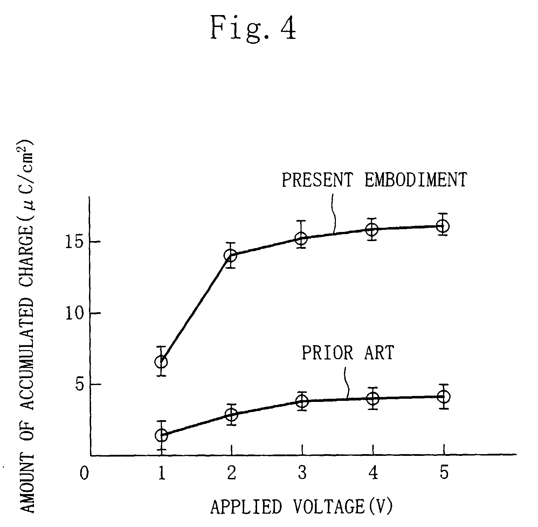

Figure **4** is a view showing for comparison the properties of the semiconductor device according to the present embodiment and the properties of the conventional semiconductor device shown in Figure **5**. Figure **4** shows the relationship between a voltage applied between the semiconductor substrate and the capacitor upper electrode and the amount of charge (corresponding to the amount of residual dielectric polarization) accumulated in the capacitor insulating film.

As can be seen from Figure **4**, if the same voltage is assumed to be applied, the amount of charge accumulated in the capacitor insulating film in the semiconductor device according to the present embodiment is about five times the amount of charge accumulated in the capacitor insulating film in the conventional semiconductor device. A consideration will be given to the reason for the significant increase in the amount of charge accumulated in the capacitor insulating film.

In the conventional semiconductor device, oxygen in the atmosphere or in the ferroelectric film enters the diffusion preventing film **106** during the formation of the ferroelectric film serving as the capacitor insulating film **108** so that a high resistance layer is formed in the diffusion preventing film **106**. If a voltage is applied between the semiconductor substrate **100** and the capacitor upper electrode **109**, a part of the applied voltage is applied to the high resistance layer so that the voltage applied to the capacitor insulating film **108** is reduced and therefore the amount of charge accumulated in the capacitor insulating film **108** is reduced.

By contrast, the sidewalls **18** made of silicon nitride are provided on the side surfaces of the diffusion preventing film **16** in the semiconductor device according to the present embodiment so that oxygen in the atmosphere or in the ferroelectric film is blocked by the sidewalls **18** and does not enter the diffusion preventing film **16** during the formation of the ferroelectric film serving as the capacitor insulating film **19**. As a result, a high resistance layer is not formed in the diffusion preventing film **16**. When the voltage is applied between the semiconductor substrate **10** and the capacitor upper electrode **20**, the applied voltage is not applied to the resistance layer so that the amount of charge accumulated in the capacitor insulating film **19** increases significantly.

Although the sidewalls **18** cover the entire side surfaces of the diffusion preventing film **16** and a part of the side surfaces of the capacitor lower electrode **17** in the present embodiment, the sidewalls **18** may cover only the entire side surfaces of the diffusion preventing film **16** without covering the side surfaces of the capacitor lower electrode. Alternatively, the sidewalls **18** may cover the entire side surfaces of the diffusion preventing film **16** and the capacitor lower electrode.

Although the sidewalls **18** are formed of silicon nitride in the present embodiment, the same effects are achievable if another oxidation resistant material is used instead. In this case, if there is the possibility that hydrogen contained in the sidewalls **18** is diffused in the capacitor insulating film **18** and reduces the capacitor insulating film **19**, an insulating oxide containing no hydrogen is preferably used to form the sidewalls **18**. When an insulating oxide is used, it is preferable to use aluminum oxide, zirconium oxide, iridium oxide, rhodium oxide, ruthenium oxide, or the like which is eminently thermally stable with the view to preventing a situation in which the insulating oxide is decomposed to generate oxygen and the generated oxygen enters the diffusion preventing film **16**.

Although the contact plug **15** is formed of polysilicon in the present embodiment, tungsten or the like may also be used instead to form the contact plug **15**.

Although the diffusion preventing film **16** is formed of titanium nitride in the present embodiment, the diffusion preventing film **16** may also be formed of a single-layer or multi-layer film having a film made of titanium, tantalum, tungsten, aluminum, or a film made of titanium nitride, tantalum nitride, tungsten nitride, aluminum nitride, or an alloy thereof. The film made of any of the materials listed above has a close-knit texture, a remarkable ability to prevent diffusion, and excellent adhesion to the protective insulating film **14** and is prone to oxidation.

Although the capacitor lower electrode **17** is formed of the multi-layer film consisting of the iridium film and the iridium oxide film in the present embodiment, the capacitor lower electrode **17** may also be formed of a single-layer or multi-layer film having a film made of platinum, iridium, ruthenium, rhodium, or an oxide thereof. However, the capacitor lower electrode **17** is preferably formed of a single-layer conductive oxide film such as an iridium oxide film, which is superior in preventing the diffusion of oxygen, or of a multi-layer film consisting of the conductive oxide film and a platinum film, an iridium film, a ruthenium film, or a rhodium film.

Although the capacitor upper electrode **20** is formed of a platinum film in the present embodiment, the capacitor upper electrode **20** may also be formed of a single-layer or multi-layer film composed of iridium, ruthenium, rhodium, or an oxide thereof.

Although the capacitor insulating film **19** is formed of a ferroelectric material such as SrBi₂(Ta₁₋ₓNbₓ)O₉, the capacitor insulating film **19** may also be formed of another ferroelectric material having a bismuth layered perovskite structure or of an insulating metal oxide such as lead zirconate titanate, strontium barium titanate, or tantalum pentaoxide.

As the semiconductor substrate **10**, there may be used a semi-insulating substrate made of, e.g., GaAs, a semiconductor substrate formed with a conductive region, a semiconductor substrate formed with a transistor composed of an impurity diffusion layer serving as a source or drain region and a gate electrode, or the like.

## Claims

1. A semiconductor device comprising:
a protective insulating film deposited on a semiconductor substrate having a field-effect transistor formed thereon;
a contact plug formed in the protective insulating film to have a lower end portion connected to an impurity diffusion layer serving as a source or drain region of the field-effect transistor;
a conductive diffusion preventing film formed on the protective insulating film and connected to an upper end portion of the contact plug;
sidewalls made of an oxidation resistant material and formed on at least side surfaces of the diffusion preventing film;
a capacitor lower electrode formed on the diffusion preventing film;
a capacitor insulating film made of an insulating metal oxide and formed over the capacitor lower electrode and the sidewalls; and
a capacitor upper electrode formed on the capacitor insulating film.

2. The semiconductor device of claim 1, wherein the sidewalls are made of silicon nitride.

3. The semiconductor device of claim 1, wherein the sidewalls are made of an insulating metal oxide.

4. The semiconductor device of claim 3, wherein the metal oxide is aluminum oxide, zirconium oxide, iridium oxide, rhodium oxide, or ruthenium oxide.

5. The semiconductor device of claim 1, wherein the capacitor insulating film is made of a ferroelectric material having a bismuth layered perovskite structure, lead zircoriate titanate, strontium barium titanate, or tantalum pentaoxide.

6. The semiconductor device of claim 1, wherein the diffusion preventing film is composed of a single-layer or multi-layer film having a film made of titanium, tantalum, tungsten, aluminum, or an alloy thereof or a film made of titanium nitride, tantalum nitride, tungsten nitride, aluminum nitride, or an alloy thereof.

7. A method of fabricating a semiconductor device, the method comprising the steps of:
depositing a protective insulating film on a semiconductor substrate having a field-effect transistor formed thereon;
forming a contact plug in the protective insulating film such that a lower end portion of the contact plug is connected to an impurity diffusion layer serving as a source or drain region of the field-effect transistor;
forming a conductive diffusion preventing film on the protective insulating film such that the diffusion preventing film is connected to an upper end portion of the contact plug;
forming a capacitor lower electrode on the diffusion preventing film;
depositing a film made of an oxidation resistant material over the protective insulating film and the capacitor lower electrode, performing anisotropic dry etching with respect to the film made of the oxidation resistant material, and thereby forming sidewalls made of the oxidation resistant material on at least side surfaces of the diffusion preventing film;
forming a capacitor insulating film made of an insulating metal oxide over the capacitor lower electrode and the sidewalls; and
forming a capacitor upper electrode on the capacitor insulating film.
